# EUROPEAN PATENT APPLICATION

(11) **EP 1 450 361 A1**
(43) Date of publication of application: **25.08.2004**
(21) Application number: 02778065.9
(22) Date of filing: 05.11.2002
(51) Int. Cl.: G11B 7/26

(54) **METHOD FOR MANUFACTURING STAMPER FOR INFORMATION MEDIUM AND DEVICE FOR MANUFACTURING STAMPER FOR INFORMATION MEDIUM**

(30) Priority: 05.11.2001 JP 2001338804
(71) Applicant: TDK Corporation, Chuo-ku, Tokyo 103-8272 (JP)
(72) Inventor: OYAKE, Hisaji, Tokyo 103-8272 (JP); TAKAHATA, Hiroaki, Tokyo 103-8272 (JP); UTSUNOMIYA, Hajime, Tokyo 103-8272 (JP)
(74) Representative: HOFFMANN - EITLE
(86) International application number: PCT/JP2002/011535
(87) International publication number: WO 2003/041070

(57) **Abstract**

A method for manufacturing a stamper for an information medium in which a light absorbing layer (22) containing a beam absorbing material to absorb a laser beam (L) is formed on a glass base (21), a photoresist layer (23) is formed on the light absorbing layer (22), the photoresist layer (23) is irradiated with the laser beam (L) to form a latent image, the photoresist layer (23) is developed, and a photoresist matrix (2) with a protrusion/depression pattern formed thereon is fabricated, stamper forming members (11 and 12) are formed on the surface with the protrusion/depression pattern formed thereon of the photoresist matrix (2), the glass base (21) of the photoresist matrix (2) is removed, and the light absorbing layer (22) is removed together with the photoresist layer (23) by using strong alkaline solution. Since multiple exposure of the photoresist layer (23) can be thus avoided, a photoresist matrix (2) with a sharp protrusion/depression pattern and a stamper for information medium can be manufactured thereby. In addition, the photoresist layer (23) can be reliably dissolved and removed with strong alkaline solution in a short time, and the light absorbing layer (22) can be easily removed from the stamper forming members (11 and 12) in a short time.

## Description

### TECHNICAL FIELD

The present invention relates to a method for manufacturing a stamper for an information medium and a device for manufacturing a stamper for an information medium that manufacture a stamper for an information medium by transferring a protrusion/depression pattern formed in a photoresist matrix to stamper forming members.

### RELATED ART

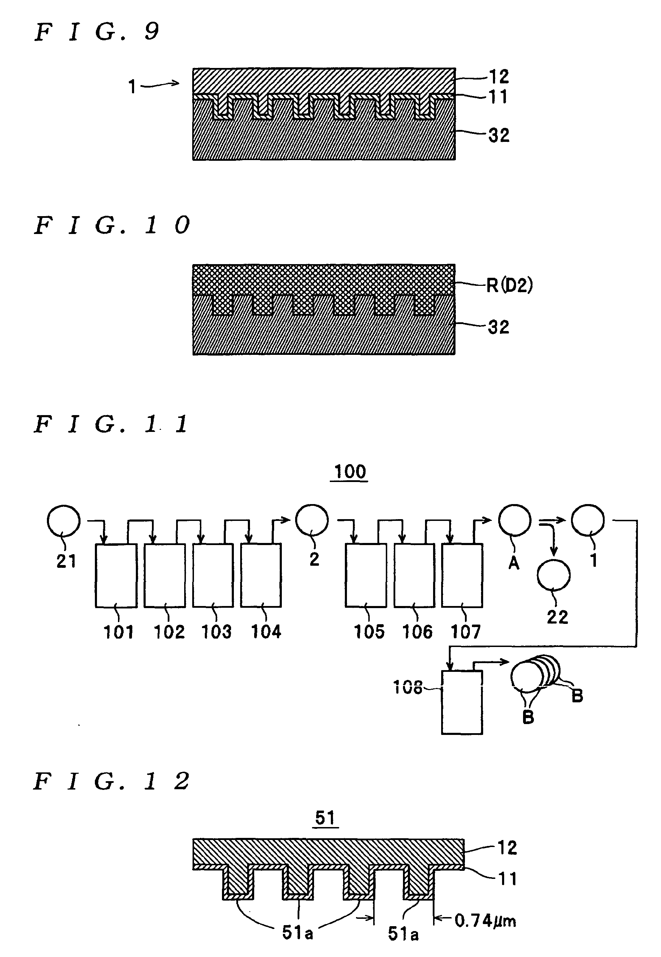

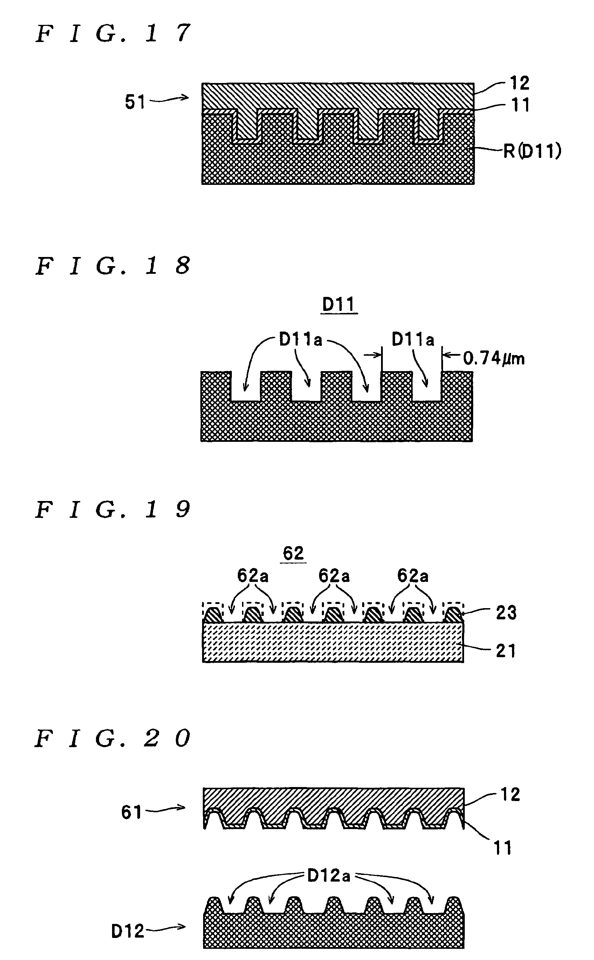

A stamper 51 shown in FIG. 12 is conventionally known as one example of a stamper for an information medium that is manufactured according to this type of method for manufacturing. When manufacturing a disc base D11 (see FIG. 18) for an optical recording medium, this stamper 51 is a stamper for optical recording medium that forms a protrusion/depression pattern, such as the guide grooves D11a for tracking control, on an upper surface of the disc base D11 and is constructed of an electro nickel layer 12 formed as a layer on a conductive layer such as an electroless nickel layer 11. This stamper 51 is formed in an overall plate-like form and protrusions 51a for forming a protrusion/depression pattern in the upper surface of the disc base D11 are formed in spirals in the lower surface thereof. In this case, the pitch of adjacent protrusions 51a, 51a (the formation pitch for the protrusions 51a) is set in accordance with the formation pitch of the guide grooves D11a of the disc base D11, at around 0.74 µm for example.

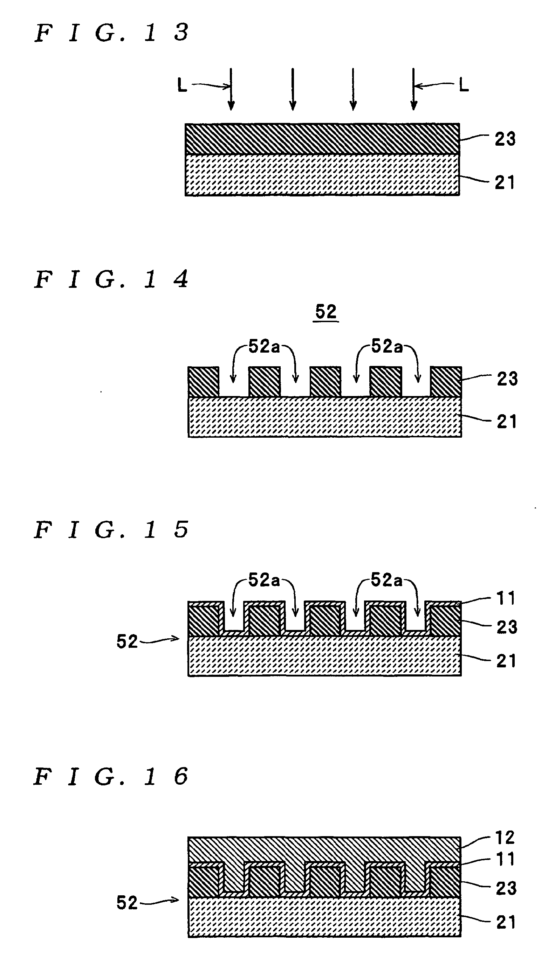

When manufacturing this stamper 51 first a photoresist matrix (shown in FIG. 14 and also referred to hereinafter as the "matrix") 52 that will be used as a mold for the stamper 51 is fabricated. The uneven form of this matrix 52 is approximately the same as the disc base D11, with recesses 52a being formed at positions at which the guide grooves D11a are formed on the disc base D11. When manufacturing this matrix 52, as shown in FIG. 13, first a photoresist layer 23 is formed on an upper surface of a glass base 21. Next, the positions where the recesses 52a are to be formed are irradiated using, for example, a patterning laser beam L (an exposing beam, which for example can have a spot diameter of 0.32 µm when sliced at a peak intensity (1/e²)) with a wavelength (λ) of 351nm that passes a lens with a numerical aperture (NA) of 0.90. By doing so, a latent image is formed in the photoresist layer 23. Next, by developing the photoresist layer 23 in this state, as shown in FIG. 14 the parts exposed by the laser beam L are removed and the recesses 52a are formed. By doing so, the matrix 52 is fabricated.

Next, when the stamper 51 is manufactured using the matrix 52, as shown in FIG. 15, first an electroless nickel layer 11 is formed, for example by electroless plating, along the protrusion/depression pattern in the photoresist layer 23. By doing so, the surface of the photoresist layer 23 is made conductive. Next, as shown in FIG. 16, an electroplating process is carried out with the electroless nickel layer 11 as an electrode to form an electro nickel layer 12 on the electroless nickel layer 11. Next, by removing the glass base 21 from the multilayer structure in this state and then soaking the structure in resist remover, the photoresist layer 23 is dissolved. By doing so, as shown in FIG. 12, the stamper 51 composed of the electroless nickel layer 11 and the electro nickel layer 12 is fabricated.

On the other hand, when an optical recording medium is manufactured using this stamper 51, after the stamper 51 has been set in a mold for forming the disc base D11, resin R is introduced to injection mold to form the disc base D11 as shown in FIG. 17. By doing so, as shown in FIG. 18, the protrusions 51a of the stamper 51 are transferred to the resin R to form the guide grooves D11a, thereby fabricating the disc base D11. In this case, when the disc base D11 is mass produced using the stamper 51, wear and tear occurs for the stamper 51 so that the corner parts of the protrusion/depression pattern become rounded and the stamper 51 becomes no longer suited to use in manufacturing. Accordingly, when the disc base D11 is mass produced, first the stamper 51 is used as a master stamper to manufacture a mother stamper onto which the protrusion/depression pattern of the stamper 51 has been transferred. Next, a child stamper is fabricated by transferring the protrusion/depression pattern of the mother stamper, and the disc bases D11 are manufactured using this child stamper. In this way, since it is possible to successively replace the child stamper in use with a new child stamper, the disc base D11 can be mass produced. In this case, depending on the application, it is also possible to use the mother disk described above as a stamper.

### DISCLOSURE OF THE INVENTION

By investigating the conventional method for manufacturing a stamper for an information medium described above, the present inventors discovered the following problem. In the conventional method for manufacturing, in the manufacturing step for the matrix 52, a latent image is formed in the photoresist layer 23 by irradiation with a laser beam with a wavelength of 351nm that is emitted via a lens with a numerical aperture of around 0.90. In this case, the formation pitch of the latent image (the recesses 52a) is limited by the spot diameter of the laser beam L. More specifically, when forming the recesses 52a with a narrower pitch than the spot diameter of the laser beam L (in this case, a pitch of 0.32 µm or smaller), there is some overlapping between an already irradiated position at which a recess 52a is formed in the photoresist layer 23 and an irradiated position at which a recess 52a is to be formed adjacent to this recess 52a. This means that the photoresist layer 23 is multiply exposed at positions where the irradiation ranges of the laser beam L overlap, and as with a matrix 62 shown in FIG. 19, this results in recesses 62a being formed shallower than the intended depth and/or having a rounded form. Accordingly, on a disc base D12 manufactured using a stamper 61 (see FIG. 20) manufactured using this matrix 62, guide grooves D12a are shallow and rounded in form, so that it becomes difficult to perform tracking correctly and therefore difficult to read and write recording data properly. On the other hand, with current information media (one example of which are optical recording media), increases in recording density are sought, so that it is necessary to make the guide grooves narrower and thereby improve the recording density. However, as described above, the formation pitch of the recesses 52a is limited by the spot diameter of the laser beam L, so that it is difficult to make the pitch of the protrusions 51a of a stamper 51 narrower, that is, it is difficult to make the guide grooves narrower on a disc base. For this reason, difficulties remain when improving the recording density by making the pitch of the guide grooves narrower.

In this case, it is conceivable to use a method of manufacturing that carries out exposure using a lens with a numerical aperture of around 0.90 and a laser beam with a wavelength of 266nm or 257nm as the exposing laser beam L, or uses a lens (SIL: Solid Immersion Lens) with a numerical aperture of around 1.30 to make the spot diameter relatively small and therefore prevent multiple exposure, so that the recesses 52a are formed with a narrow pitch. However, when a latent image is formed with a narrow formation pitch whereby the irradiation ranges of the laser beam do not overlap, there are cases where the laser beam is reflected by the glass base 21 and this reflected light results in multiple exposure of the photoresist layer 23, thereby causing the latent image to break up. In such cases, the recesses 52a are shallowly formed and/or are rounded in form, so that it becomes difficult to manufacture an optical recording medium that can be read and written properly. Also, when a laser device (also referred to as an "exposing device" or "cutting device") that can emit a laser beam with a small spot diameter is newly introduced, there is the problem of a large increase in the manufacturing costs of the matrices 52, 62 and in turn in the manufacturing costs of the stamper 51 and the optical recording medium. It is also conceivable to use a method of forming a latent image that uses an electron beam, whose spot diameter can be made small, in place of a laser beam. However, when an exposing device that emits an electron beam is used, the exposing device itself is expensive and also requires extremely complex maintenance, so that there is the problem of a large increase in the manufacturing cost of the stamper 51 and the optical recording medium.

On the other hand, Japanese Laid-Open Patent Publication No. H04-263140 discloses a method of manufacturing that applies a non-reflective coating to one or both surfaces of a glass plate (1) to inhibit reflection of the laser beam by the glass plate and thereby prevent multiple exposure of a photoresist (3). However, with this method of manufacturing, when a latent image is formed in the photoresist with an extremely narrow pitch of 0.32 µm or narrower, for example, the photoresist is multiply exposed and the latent image breaks up. In such cases, the recesses are formed shallowly and/or are rounded in form, so that it is difficult to manufacture optical recording media that can be read and written properly.

Also, out of the glass matrices disclosed by the above patent publication, with a glass matrix (see FIG. 3 of the publication) where a non-reflective coating layer (6) is formed on an upper surface of the glass plate and then a primer layer (2) and a photoresist layer (3) are formed on top of this, depending on the material used as the non-reflective coating layer (for example, in the case where a resin is used as a binder), there is the problem when a stamper is manufactured using this glass matrix that it can be difficult to remove the glass matrix (which corresponds to the matrix 52 described above) from the stamper. That is, when the glass plate is removed after the stamper has been formed by forming an electroless nickel layer and an electro nickel layer, for example, on this glass matrix, there are cases where the non-reflective coating layer is removed from the glass plate and remains on the photoresist. In such cases, when the multilayer structure composed of the electroless nickel layer, the electro nickel layer, the photoresist layer, and the non-reflective coating layer is soaked in resist remover, the dissolving of the photoresist is hindered by the non-reflective coating layer.

The present invention was conceived to solve the problems described above, and it is a principal object of the present invention to provide a method for manufacturing a stamper for an information medium and a device for manufacturing a stamper for an information medium that can reliably and easily manufacture guide grooves with a narrow pitch without a large increase in manufacturing cost.

A method of manufacturing a stamper for an information medium according to the present invention includes steps of: forming a light absorbing layer, containing a beam absorbing material that absorbs an exposing beam, on a base; forming a photoresist layer on the light absorbing layer; irradiating the photoresist layer formed above the base with the exposing beam to form a latent image, and then developing the photoresist layer to fabricate a photoresist matrix in which a protrusion/depression pattern is formed; forming a stamper forming member on a surface of the photoresist matrix with the protrusion/depression pattern formed thereon; removing the base of the photoresist matrix; and removing the light absorbing layer together with the photoresist layer using a strong alkaline solution to manufacture a stamper for an information medium.

Also, a manufacturing apparatus for a stamper for an information medium according to the present invention includes: a light absorbing layer forming device that forms a light absorbing layer, containing a beam absorbing material that absorbs an exposing beam, on a base; a photoresist layer forming device that forms a photoresist layer on the light absorbing layer; an exposing device that forms a latent image by irradiating the photoresist layer with the exposing beam; a developing device that fabricates a photoresist matrix in which a protrusion/depression pattern is formed by developing the photoresist layer in which the latent image has been formed; a conductive layer applying device that applies the conductive layer onto a surface of the photoresist matrix with the protrusion/depression pattern formed thereon; a stamper forming member forming device that forms a stamper forming member on the conductive layer; and a removing device that strips the light absorbing layer together with the photoresist layer from the stamper forming member using a strong alkaline solution.

With this method of manufacturing and manufacturing apparatus for a stamper for an information medium, a photoresist layer is formed on the light absorbing layer that uses a beam absorbing material and is formed on a base, this photoresist layer is irradiated with an exposing beam to form a latent image and is then developed to fabricate a photoresist matrix with a protrusion/depression pattern. A stamper forming member is formed on a surface of this photoresist matrix in which the protrusion/depression pattern is formed, the base of the photoresist matrix is removed, and then the light absorbing layer is removed together with the photoresist layer using a strong alkaline solution, so that it is possible, with the light absorbing layer, to prevent multiple exposure of the photoresist layer and it is therefore possible to form a sharp latent image with a narrow pitch. Accordingly, even if a protrusion/depression pattern for forming guide grooves of a disc base is formed with a narrow pitch, the protrusion/depression pattern can be sharply formed, so that by using this stamper for an information medium, it is possible to manufacture a disc base with guide grooves that can favorably avoid tracking errors and the like. In this case, without carrying out irradiation with a laser beam with a special wavelength via a lens with a special numerical aperture or an electron beam, it is possible to form a latent image in the photoresist layer with a narrow pitch, so that it is possible to reduce the manufacturing cost of a stamper for an information medium and in turn the manufacturing cost of an information medium. Also, by using a strong alkaline solution as the remover, it is possible to reliably dissolve the photoresist layer in a short time, so that the light absorbing layer can be reliably and easily removed from a stamper for an information medium. Accordingly, by using this stamper for an information medium, it is possible to manufacture a disc base with guide grooves that can favorably prevent tracking errors and the like.

In this case, with the method for manufacturing a stamper for an information medium according to the present invention, it is preferable to use an aqueous sodium hydroxide solution as the strong alkaline solution. Also, with the manufacturing apparatus for a stamper for an information medium according to the present invention, it is preferable for the removing device to use an aqueous sodium hydroxide solution as the strong alkaline solution. By doing so, it is possible to reliably and easily remove the light absorbing layer from the stamper for an information medium.

Also, with the method for manufacturing a stamper for an information medium according to the present invention, it is preferable to form the light absorbing layer with a mixture of 4,4'-bis (diethylamino) benzophenone, as a light absorbent, and melanine resin as the beam absorbing material. Also, with the manufacturing apparatus for a stamper for an information medium according to the present invention, it is preferable for the light absorbing layer forming device to use a mixture of 4,4'-bis (diethylamino) benzophenone, as a light absorbent, and melanine resin as the beam absorbing material. By doing so, the laser beam and the like used to irradiate the photoresist layer during exposure is absorbed by the 4,4'-bis (diethylamino) benzophenone, so that a sharp latent image with a narrow pitch can be reliably and easily formed.

In addition, with the method for manufacturing a stamper for an information medium according to the present invention, it is preferable for the stamper forming member to be formed by depositing a metal material on the photoresist matrix. Also, with the manufacturing apparatus for a stamper for an information medium according to the present invention, it is preferable for the stamper forming member forming device to form the stamper material by depositing a metal material on a surface of the photoresist matrix with the protrusion/depression pattern formed thereon. By doing so, it is possible to correctly transfer the protrusion/depression pattern of the photoresist matrix compared to a method of manufacturing that uses resin or the like as the stamper forming member.

In addition, the method for manufacturing a stamper for an information medium according to the present invention manufactures a first stamper for transferring a protrusion/depression pattern onto an information medium by transferring a protrusion/depression pattern of a master stamper with a stamper for an information medium manufactured according to the above method for manufacturing being used as the master stamper. Also, a manufacturing apparatus for a stamper for an information medium according to the present invention includes a transfer device that manufactures a first stamper for transferring a protrusion/depression pattern onto the information medium by using the stamper forming member from which the light absorbing layer has been removed as a master stamper. By doing so, when disc bases for information media are mass produced, it is possible to successively replace the stamper for the information medium in use with a new stamper, so that it is possible to mass produce disc bases with sharper guide grooves having a rounded form.

It should be noted that the disclosure of the present invention relates to a content of Japanese Patent Application 2001-338804 that was filed on 5 November 2001 and the entire content of which is herein incorporated by reference.

### BRIEF DESCRIPTION OF THE DRAWINGS

FIG. 1 is a cross-sectional view of a stamper 1 according to an embodiment of the present invention.

FIG. 2 is a cross-sectional view of a state where a light absorbing layer 22 has been formed on a glass base 21 in a manufacturing process of a matrix 2.

FIG. 3 is a cross-sectional view of a state where a photoresist layer 23 formed on the light absorbing layer 22 has been irradiated with an exposing laser beam L in the manufacturing process of the matrix 2.

FIG. 4 is a cross-sectional view of a fabricated matrix 2.

FIG. 5 is a cross-sectional view of a state where the electroless nickel layer 11 has been formed on the matrix 2 in the manufacturing process of the stamper 1.

FIG. 6 is a cross-sectional view of a state where the electro nickel layer 12 has been formed on the electroless nickel layer 11.

FIG. 7 is a cross-sectional view of a state where a protrusion/depression pattern of the stamper 1 has been transferred to resin R (a disc base D1).

FIG. 8 is a cross-sectional view of the disc base D1 according to an embodiment of the present invention.

FIG. 9 is a cross-sectional view of a state where a mother stamper 32 has been fabricated by transferring the protrusion/depression pattern of the stamper 1.

FIG. 10 is a cross-sectional view of a state where a disc base D2 has been fabricated by transferring a protrusion/depression pattern of the mother stamper 32.

FIG. 11 is a block diagram of the manufacturing device 100 for a stamper according to an embodiment of the present invention.

FIG. 12 is a cross-sectional view of a conventional stamper 51.

FIG. 13 is a cross-sectional view of a state where a photoresist layer 23 formed on a glass base 21 has been irradiated with an exposing laser beam L in a manufacturing process of a matrix 52.

FIG. 14 is a cross-sectional view of a fabricated matrix 52.

FIG. 15 is a cross-sectional view of a state where an electroless nickel layer 11 has been formed on the matrix 52 in a manufacturing process of a stamper 51.

FIG. 16 is a cross-sectional view of a state where an electro nickel layer 12 has been formed on an electroless nickel layer 11.

FIG. 17 is a cross-sectional view of a state where a protrusion/depression pattern of the stamper 51 has been transferred to the resin R (the disc base D1).

FIG. 18 is a cross-sectional view of a conventional disc base D11.

FIG. 19 is a cross-sectional view of a matrix 62 manufactured according to a conventional method for manufacturing.

FIG. 20 is a cross-sectional view of a stamper 61 manufactured using the matrix 62 and a disc base D12 manufactured using the stamper 61.

### BEST MODE FOR CARRYING OUT THE INVENTION

Preferred embodiments of a method and device for manufacturing a stamper for an information medium according to the present invention will now be described with reference to the attached drawings. It should be noted that an optical recording medium is described as one example of an information medium, and component elements of the same construction as the stamper 51 and the matrix 52 in the conventional method for manufacturing are designated by the same reference numerals and description of such has been omitted.

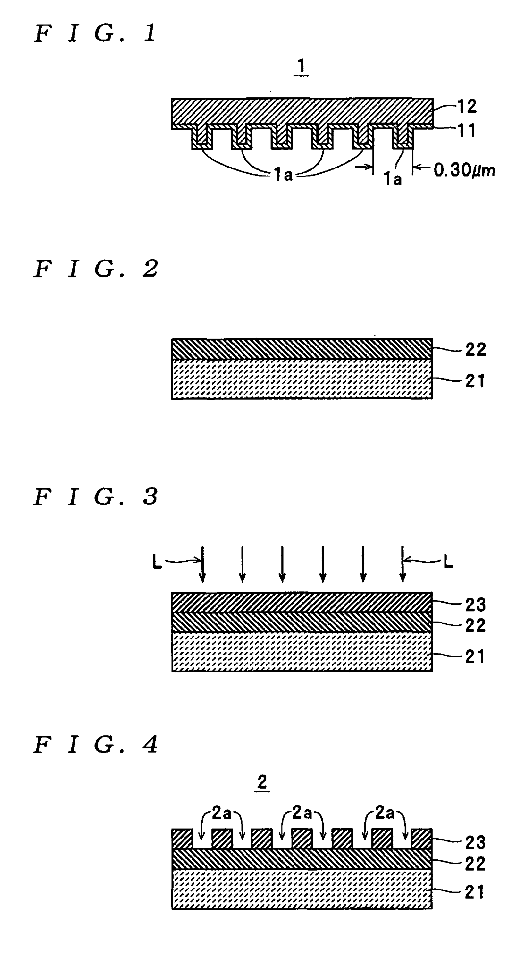

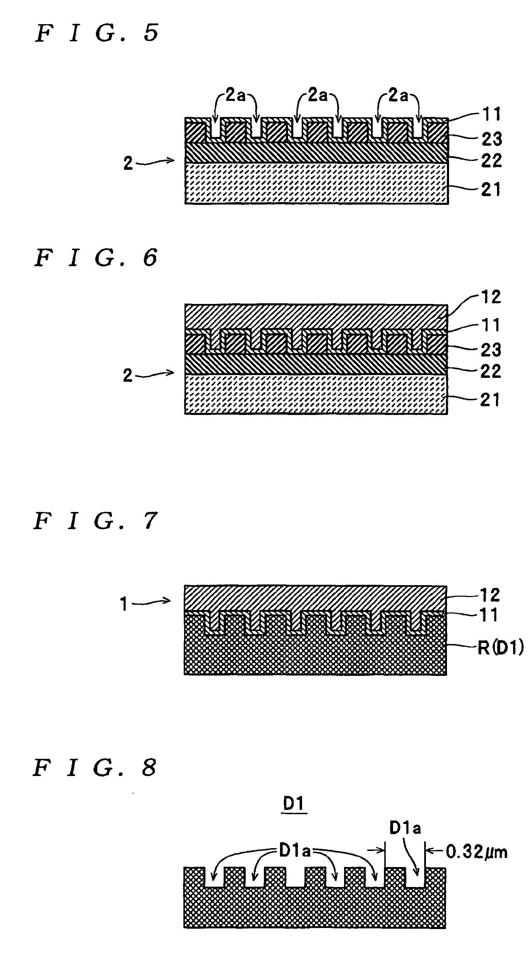

A stamper 1 shown in FIG. 1 corresponds to a stamper for an information medium according to the present invention, and is used when the disc base D1 for an optical recording medium (see FIG. 8) is injection molded or when a mother stamper 32 (see FIG. 9) is manufactured. This stamper 1 is composed of an electro nickel layer 12 formed on an electroless nickel layer 11, and is plate-like in its overall form. Also, fine protrusions 1a for forming a fine protrusion/depression pattern in an upper surface of the disc base D1 are formed in spirals in the lower surface of the stamper 1. In this case, the pitch (formation pitch of the protrusions 1a) between adjacent protrusions 1a, 1a is set in accordance with the formation pitch of the guide grooves D1a of the disc base D1 at 0.30 µm, for example.

Next, a manufacturing device 100 for manufacturing the stamper 1 will be described with reference to FIG. 11.

This manufacturing device 100 includes a light absorbing layer forming device 101, a photoresist layer forming device 102, an exposing device 103, a developing device 104, a conductive layer applying device 105, a stamper forming member forming device 106, and a removing device 107, and is constructed so as to be able to manufacture the stamper 1 using the glass base 21.

By using the manufacturing device 100 when manufacturing the stamper 1, first a photoresist matrix (hereinafter also referred to as the "matrix") 2 shown in FIG. 4 is manufactured. This matrix 2 is constructed of the glass base 21, a light absorbing layer 22, and the photoresist layer 23 that are formed in layers in order, with fine recesses 2a for forming the protrusions 1a of the stamper 1 being formed in spirals thereon.

The light absorbing layer 22 is formed with a thickness of around 150nm, for example. It should be noted that there are no particular limitations on the thickness of the light absorbing layer 22, but the light absorbing layer 22 is formed with a thickness that can sufficiently absorb the exposing laser beam L during exposure of the photoresist layer 23. More specifically, the light absorbing layer 22 should preferably have an absorption coefficient k for the laser beam L of 0.01 or greater, and preferably in a range of 0.1 or greater. When the light absorbing layer 22 is not sufficiently thick, it is not possible to sufficiently absorb the laser beam L and the latent image formed in the photoresist layer 23 breaks up. On the other hand, if the light absorbing layer 22 is formed with a thickness in excess of 300nm, the material forming the light absorbing layer 22 is consumed unnecessarily without significantly improving the light absorbency for the laser beam L. Also, if the light absorbing layer 22 is formed with a thickness in excess of 300nm, the light absorbing layer 22 excessively stores heat when irradiated with the laser beam L, which causes thermal decomposition in the photoresist layer 23, and as a result, stable exposure of the photoresist layer 23 tends to be difficult. Accordingly, it is preferable to set the thickness of the light absorbing layer 22 in a range of 1nm to 300nm, inclusive, and more preferably in a range of 10nm to 150nm inclusive. In this case, the degree of thermal decomposition of the photoresist layer 23 due to heat storage of the light absorbing layer 22 described above varies according to the irradiation power of the irradiating laser beam L. This means that when the exposure is carried out using a laser beam L with comparatively low power, it is also possible to set the thickness of the light absorbing layer 22 in a range above 300nm but no greater than 500nm.

The light absorbing layer 22 includes an organic compound with light absorption characteristics for the wavelength of the laser beam L emitted during exposure (such organic compound corresponds to the "beam absorbing material" for the present invention, and is also referred to as a "light absorbent"), and for example, it is possible to use a co-initiator, a dye, or a mixture of a co-initiator and a dye. In this case, the co-initiator is composed of an organic compound that absorbs light such as UV rays. In this embodiment of the invention, 4,4'-bis (diethylamino) benzophenone (hereinafter also referred to a "benzophenone compound") is used as one example of a light absorbent. The photoresist layer 23 is a layer for forming a protrusion/depression pattern in the upper surface of the stamper 1, and is around 30nm thick, for example. In this embodiment of the invention, a photoresist (DVR100 manufactured by ZEON CORPORATION of Japan) is used as the material of the photoresist layer 23.

When the matrix 2 is fabricated, first, the benzophenone compound is dissolved in a melamine resin (thermal hardening resin), in which melanine and formalin, for example, have been combined to fabricate an applied liquid for forming the light absorbing layer 22. The fabricated applied liquid is stored inside the light absorbing layer forming device 101. At this time, it is possible to use a UV-hardening resin in place of the melamine resin. Also, to improve adhesion with the photoresist layer 23 that will be formed later, it is possible to fabricate the applied liquid by adding various types of additives, such as an adhesive auxiliary, a light absorbent, and a surface active agent. In addition, in place of the mixture of the 4,4'-bis (diethylamino) benzophenone and the melamine resin, it is possible to use a mixture in which various kinds of light absorbent can be mixed with a thermal hardening resin, light-curing resin, or the like.

In the manufacturing device 100, first, the light absorbing layer forming device 101 forms the light absorbing layer 22 on the glass base 21. More specifically, after forming a coupling agent layer (not illustrated) on the glass base 21 whose surface has been polished flat, as shown in FIG. 2, the light absorbing layer forming device 101 applies the applied liquid that includes a light absorbent onto the glass base 21 by spin coating. Next, the light absorbing layer forming device 101 hardens the applied film by carrying out a heating process on the glass base 21 in this state. It should be noted that when UV-hardening resin is used during the fabrication of the applied liquid, the light absorbing layer forming device 101 hardens the applied film by irradiating the applied liquid after application with UV rays. By doing so, the light absorbing layer 22 is formed on the glass base 21. Next, after spin coating the photoresist on the light absorbing layer 22, the photoresist layer forming device 102 evaporates the remaining solvent by baking. By doing so, as shown in FIG. 3, the photoresist layer 23 is formed on the light absorbing layer 22.

Next, the exposing device 103 (a so-called "cutting machine") irradiates parts at which the recesses 2a (parts at which the guide grooves D1a of the disc base D1 will be formed) are formed via a lens with a numerical aperture (NA) of 0.90, for example, with a patterning laser beam L with a wavelength (λ) 351nm (an exposing beam, for example, a laser beam with a spot diameter 0.32 µm when sliced with a peak intensity (1/e²)). By doing so, a spiral latent image with a formation pitch of around 0.30 µm and width of around 0.15 µm, for example, is formed in the photoresist layer 23. In this case, since the light absorbing layer 22 is formed between the glass base 21 and the photoresist layer 23, the majority of the laser beam L that has been emitted from the exposing device 103 and passed through the photoresist layer 23 (and formed the latent image) is absorbed by the light absorbing layer 22 and so does not reach the glass base 21. On the other hand, the small amount of the laser beam L that has not been absorbed by the light absorbing layer 22 and has reached and been reflected by the glass base 21 is absorbed by the light absorbing layer 22 without reaching the photoresist layer 23. Accordingly, reflection by the glass base 21 is inhibited and multiple exposure of the photoresist layer 23 is prevented, so that a sharp latent image is formed with a narrow (slim) pitch. Next, the developing device 104 develops the photoresist layer 23 in this state, as shown in FIG. 4, to remove the parts irradiated with the laser beam L and thereby form the recesses 2a. In this way, the matrix 2 is fabricated.

Next, in the manufacturing device 100, as shown in FIG. 5, the conductive layer applying device 105 first forms the electroless nickel layer 11 (conductive layer) composed of nickel as the metal material by electroless plating (deposition) along the protrusion/depression pattern of the photoresist layer 23. By doing so, the surface of the photoresist layer 23 is made conductive. In this case, the material for forming the layer (conductive layer) that makes the surface of the photoresist layer 23 conductive is not limited to nickel, and it is possible to use various types of metal material. The method for forming the conductive layer is not limited to electroless plating and various types of metal material layer (for example, nickel layer) can be formed by various types of film forming methods, such as vapor deposition or sputtering. Next, as shown in FIG. 6, the stamper forming member forming device 106 forms (laminates) the electro nickel layer 12 on the electroless nickel layer 11 by carrying out an electroless plating process (deposition) using the electroless nickel layer 11 as an electrode. In this case, the electro nickel layer 12 formed by the stamper forming member forming device 106 is the "stamper forming member" for the present invention and the multilayer structure (also referred to as the "stamper multilayer structure") composed of the electroless nickel layer 11 and the electro nickel layer 12 constructs the stamper 1.

Next, after the glass base 21 has been removed from the matrix 2 on which the stamper multilayer structure is formed, the removing device 107 soaks the multilayer structure composed of the stamper multilayer structure, the light absorbing layer 22, and the photoresist layer 23 in a 20% by weight aqueous solution of sodium hydroxide to dissolve and remove the photoresist layer 23. By doing so, the light absorbing layer 22 can be easily removed from the multilayer structure. Since an aqueous solution sodium hydroxide is a strong alkaline solution that is more alkaline than a normal photoresist stripper, the photoresist layer 23 only can be dissolved in a short time (for example, around three minutes) without the light absorbing layer 22 dissolving. In this case, even if the multilayer structure is soaked in a remover used in a conventional method of manufacturing for around one day, for example, the photoresist layer 23 will still not completely dissolve, so that there will be some difficulty removing the light absorbing layer 22. On the other hand, when an aqueous solution of sodium hydroxide is used as the remover, the photoresist layer 23 can be completely dissolved in a short time, so that the light absorbing layer 22 can be stripped reliably and in a short time. By doing so, the stamper 1 (see FIG. 1) is fabricated.

On the other hand, when an optical recording medium is manufactured using the fabricated stamper 1, as one example, resin R is introduced into a mold in which the stamper 1 has been set to injection mold the disc base D1 as shown in FIG. 7. By doing so, as shown in FIG. 8, the protrusions 1a of the stamper 1 are transferred to the resin R to form the guide grooves D1a, thereby fabricating the disc base D1. Also, when mass producing the disc base D1, as one example, as shown in FIG. 11, it is preferable to add a transfer device 108 to the manufacturing device 100 so as to make the manufacturing device 100 capable of manufacturing a plurality of child stampers (one example of a "first stamper" for the present invention) B, B, ... using the transfer device 108. In this case, as shown in FIG. 9, the transfer device 108 first uses the stamper 1 as a master stamper and fabricates a mother stamper 32 by transferring the protrusion/depression pattern of the master stamper to a metal material, for example. Next, the transfer device 108 fabricates a plurality of child stampers B, B, ... by transferring the protrusion/depression pattern of the mother stamper 32. When manufacturing the disc base D1, one of these child stampers B is used. This means that it is possible to successively replace the child stamper B in use with a new child stamper B before it wears out, so that it is possible to mass produce the disc base D1.

In this case, depending on the application, it is also possible to use the mother stamper 32 as a stamper (another example of the "first stamper" for the present invention). As shown in FIG. 10, the mother stamper 32 is used as a stamper and the resin R is introduced into the mold in which the stamper (the mother stamper 32) has been set. By doing so, as shown in FIG. 10, a disc base D2 that has the reverse of the protrusion/depression pattern of the disc base D1 is injection molded. In this way, the method for manufacturing the disc base D2 using the mother stamper 32 as the stamper can be effectively used when manufacturing disc bases for high-density optical recording media that have been investigated in recent years. A blue laser is used as the playback laser beam and the recording laser beam of high-density optical recording media, so that it is necessary to bring the pickup close to the recording layer during recording and playback. Accordingly, since the irradiation direction of the laser beam is reversed compared to conventional optical recording media and the irradiation with the laser beam is carried out on the light transmitting layer side that is thinner than the disc base, it is necessary to manufacture the disc base with a protrusion/depression pattern that is the reverse of that on a normal disc base. This means that by using a mother stamper 32 with a protrusion/depression pattern that is the reverse of the stamper 1 as the stamper, it is possible to easily manufacture a disc base for a high-density optical recording medium.

In this way, according to the method of manufacturing the optical recording medium stamper (the stamper 1) and the manufacturing device 100, when the matrix 2 is manufactured, the light absorbing layer 22 is formed between the glass base 21 and the photoresist layer 23, and by having the light absorbing layer 22 absorb the laser beam L, multiple exposure of the photoresist layer 23 due to reflection by the glass base 21 can be avoided, resulting in it being possible to form a sharp latent image with a narrow pitch. By doing so, it is possible to sharply form the protrusions 1a, 1a, ... for forming the guide grooves, and by using this stamper 1 when manufacturing the disc base D1, it is possible to form guide grooves that can favorably prevent tracking errors and the like in the disc base D1. In this case, with this method of manufacturing and the manufacturing device 100, even if a latent image is formed with a narrower pitch than the spot diameter of the laser beam L, multiple exposure is avoided due to absorption by the light absorbing layer 22, so that a relatively sharp latent image is formed. Accordingly, by manufacturing the disc base D1 using the stamper 1 formed using this method of manufacturing and the manufacturing device 100, it is possible to considerably improve the recording density for recorded data. Even in the case where the disc base D2 is manufactured using the mother stamper 32 as a stamper, the protrusions 1a, 1a, ... of the stamper 1 for forming the mother stamper 32 described above can be sharply formed with a narrow pitch, so that the recesses (recesses formed in the mother stamper 32 by the protrusions 1a, 1a,...) for forming the guide grooves of the disc base D2 can be formed sharply, making it possible to form guide grooves that can favorably avoid tracking errors and the like in the disc base D2. As a result, it is possible to considerably improve the recording density for recording data.

In addition, according to this method of manufacturing and the manufacturing device 100, by using an aqueous solution of sodium hydroxide as a remover for removing the photoresist layer 23, it is possible to reliably remove the light absorbing layer 22 from the stamper multilayer structure in a short time. As a result, it is possible to make a removal process or removing device for the photoresist layer 23 that uses O₂ plasma or the like unnecessary, so that it is possible to sufficiently reduce the manufacturing cost. Also, by forming the light absorbing layer 22 using an applied liquid composed of a mixture of 4,4'-bis (diethylamino) benzophenone and the melamine resin, the majority of the laser beam L that has passed the photoresist layer 23 (and formed the latent image) during exposure of the photoresist layer 23 is absorbed by the light absorbing layer 22 and does not reach the glass base 21, and the extremely small amount of the laser beam L that has not been absorbed and so has reached and been reflected by the glass base 21 is also being absorbed by the light absorbing layer 22 without reaching the photoresist layer 23, so that it is possible to effectively prevent multiple exposure of the photoresist layer 23, resulting in it being possible to form a sharp latent image with a narrow pitch.

In addition, by adding the transfer device 108, fabricating the mother stamper 32 with the stamper 1 as a master stamper, and carrying out a process that manufactures a plurality of stampers (child stampers) using this mother stamper 32, it is possible to successively replace the stamper with a new stamper, so that it is possible to mass produce disc bases D1 whose guide grooves D1a have sharp groove shapes.

It should be noted that the present invention is not limited to the embodiment described above, and can be modified as appropriate. As one example, although an example where the glass base 21 is used when manufacturing the matrix 2 has been described in the above embodiment of the invention, the base for the present invention is not limited to this and it is possible to use a variety of bases, such as a metal base, a metalloid base, and a ceramic base. The protrusion/depression pattern for the present invention is not limited to the spiral protrusion/depression pattern described as an example in the above embodiment, and the protrusion/depression pattern may be in the form of concentric circles, or in a variety of other shapes. Also, the present invention is not limited to the manufacturing of a stamper for forming guide grooves, and can be effectively applied to the formation of a stamper for forming information pits, for example. It should also be obvious that although an optical recording medium has been described above as an example of the information medium, the present invention can also be applied to magnetic discs (such as discrete media).

### INDUSTRIAL APPLICABILITY

As described above, according to the method of manufacturing and manufacturing device for an information medium stamper, a light absorbing layer including a beam absorbing material is formed on a base, a photoresist layer is formed on this light absorbing layer, and a latent image is formed by irradiating the photoresist layer formed above the base with an exposing beam and then developed, thereby fabricating a photoresist matrix in which a protrusion/depression pattern is formed. A stamper forming member is formed on the formation surface of the protrusion/depression pattern of the photoresist matrix, the material of the photoresist matrix is removed, and the light absorbing layer is removed together with the photoresist layer using a strong alkaline solution, thereby manufacturing a stamper for an information medium. In this case, it is possible to avoid multiple exposure of the photoresist layer using the light absorbing layer, so that it is possible to form a sharp latent image with a narrow pitch. In addition, since a strong alkaline solution is used, it is possible to remove the photoresist layer reliably and easily in a short time. Accordingly, it is possible to realize a method of manufacturing and manufacturing device for a stamper for an information medium that can sharply form a protrusion/depression pattern and can easily remove the light absorbing layer, even if the protrusion/depression pattern is formed with a narrow pitch for forming the guide grooves of a disc base.

## Claims

1. A method of manufacturing a stamper for an information medium, comprising steps of:
forming a light absorbing layer, containing a beam absorbing material that absorbs an exposing beam, on a base;
forming a photoresist layer on the light absorbing layer;
irradiating the photoresist layer formed above the base with the exposing beam to form a latent image, and then developing the photoresist layer to fabricate a photoresist matrix in which a protrusion/depression pattern is formed;
forming a stamper forming member on a surface of the photoresist matrix with the protrusion/depression pattern formed thereon;
removing the base of the photoresist matrix; and
removing the light absorbing layer together with the photoresist layer using a strong alkaline solution to manufacture a stamper for an information medium.

2. A method of manufacturing a stamper for an information medium according to Claim 1,
wherein an aqueous sodium hydroxide solution is used as the strong alkaline solution.

3. A method of manufacturing a stamper for an information medium according to Claim 1,
wherein the light absorbing layer is formed with a mixture of 4,4'-bis (diethylamino) benzophenone, as a light absorbent, and melanine resin as the beam absorbing material.

4. A method of manufacturing a stamper for an information medium according to Claim 2,
wherein the light absorbing layer is formed with a mixture of 4,4'-bis (diethylamino) benzophenone, as a light absorbent, and melanine resin as the beam absorbing material.

5. A method of manufacturing a stamper for an information medium according to Claim 1,
wherein the stamper forming member is formed by depositing a metal material on the photoresist matrix.

6. A method of manufacturing a stamper for an information medium that manufactures a first stamper for transferring a protrusion/depression pattern onto an information medium by transferring a protrusion/depression pattern of a master stamper with a stamper for an information medium manufactured according to a method of manufacturing of any of Claim 1 to Claim 5 being used as the master stamper.

7. A manufacturing apparatus for a stamper for an information medium, comprising:
a light absorbing layer forming device that forms a light absorbing layer, containing a beam absorbing material that absorbs an exposing beam, on a base;
a photoresist layer forming device that forms a photoresist layer on the light absorbing layer;
an exposing device that forms a latent image by irradiating the photoresist layer with the exposing beam;
a developing device that fabricates a photoresist matrix in which a protrusion/depression pattern is formed by developing the photoresist layer in which the latent image has been formed;
a conductive layer applying device that applies the conductive layer onto a surface of the photoresist matrix with the protrusion/depression pattern formed thereon;
a stamper forming member forming device that forms a stamper forming member on the conductive layer; and
a removing device that strips the light absorbing layer together with the photoresist layer from the stamper forming member using a strong alkaline solution.

8. A manufacturing apparatus for a stamper for an information medium according to Claim 7,
wherein the removing device uses an aqueous sodium hydroxide solution as the strong alkaline solution.

9. A manufacturing apparatus for a stamper for an information medium according to Claim 7,
wherein the light absorbing layer forming device uses a mixture of 4,4'-bis (diethylamino) benzophenone, as a light absorbent, and melanine resin as the beam absorbing material.

10. A manufacturing apparatus for a stamper for an information medium according to Claim 8,
wherein the light absorbing layer forming device uses a mixture of 4,4'-bis (diethylamino) benzophenone, as a light absorbent, and melanine resin as the beam absorbing material.

11. A manufacturing apparatus for a stamper for an information medium according to Claim 7,
wherein the stamper forming member forming device forms the stamper material by depositing a metal material on a surface of the photoresist matrix with the protrusion/depression pattern formed thereon.

12. A manufacturing apparatus for a stamper for an information medium according to any of Claim 7 to Claim 11,
further comprising a transfer device that manufactures a first stamper for transferring a protrusion/depression pattern onto the information medium by using the stamper forming member from which the light absorbing layer has been removed as a master stamper.
